## Europäisches Patentamt

## European Patent Office

## Office européen des brevets

(11) Veröffentlichungsnummer: **0 154 663**
**A1**

(12) **EUROPÄISCHE PATENTANMELDUNG**

(21) Anmeldenummer: **84102879.8**

(51) Int. Cl.⁴: **H 03 M 1/64**

(22) Anmeldetag: **15.03.84**

(43) Veröffentlichungstag der Anmeldung: **18.09.85**
Patentblatt **85/38**

(84) Benannte Vertragsstaaten: **FR GB IT**

(71) Anmelder: **Werba, Hans, Theresienstrasse 11, D-8390 Passau (DE)**

(72) Erfinder: **Werba, Hans, Theresienstrasse 11, D-8390 Passau (DE)**

(74) Vertreter: **Kador . Klunker . Schmitt-Nilson . Hirsch, Corneliusstrasse 15, D-8000 München 5 (DE)**

(54) **Analog/Digital-Wandler.**

(57) Analog/Digital-Wandler mit einer Laufzeitleitungsanordnung, die entlang ihrer Länge mit einer Anzahl Abgriffen versehen ist und beiden Endes mit Hilfssignalen gleicher Signalform von einer Hilfssignalquelle gespeist wird. Mittels einer steuerbaren Phasenveränderungseinrichtung wird unter Steuerung durch das umzusetzende Analogsignal ein Phasenunterschied zwischen den beiden gegenläufigen Hilfssignalen auf der Laufzeitleitungsanordnung entsprechend der Analogsignaländerung moduliert. Durch an die einzelnen Abgriffe angeschlossene Abgriffsdetektoren werden die beiden gegenläufigen Hilfssignale an den einzelnen Abgriffsstellen auf Betragsgleichheit oder Betragsungleichheit untersucht. Dabei ist an den Ausgängen aller Abgriffsdetektoren das Quantisierungsmuster abnehmbar.

A/D Wandler

0154663

Analog/Digital-Wandler

Die Erfindung betrifft einen Analog/Digital-Wandler, mit
dem Analogsignale in digitalcodierte Form gebracht werden,
in der sie beispielsweise in digitalorganisierten Computern
oder in digitalverarbeitenden und/oder anzeigenden Meßgeräten
verarbeitet werden können.

Der Erfindung liegt die Aufgabe zugrunde, einen Analog/Digital-Wandler verfügbar zu machen, mit dem sich auf eine relativ wenig aufwendige Weise Analogsignale hoher Frequenz,
beispielsweise im oberen MHz-Bereich oder auch im GHz-Bereich,
in Digitalform umsetzen lassen.

Die Lösung dieser Aufgabe besteht in einem Analog/Digital-
Wandler, der gekennzeichnet ist durch eine Laufzeitleitungsanordnung, die entlang ihrer Länge mit einer Anzahl Abgriffen
versehen ist und beiden Endes mit Hilfssignalen gleicher
Signalform von einer Hilfssignalquelle gespeist wird, durch
eine steuerbare Phasenveränderungseinrichtung, mittels der
unter  Steuerung durch das umzusetzende Analogsingal ein
Phasenunterschied zwischen den beiden gegenläufigen Hilfssignalen auf der Laufzeitleitungsanordnung entsprechend der
Analogsignaländerung modulierbar ist, und durch an die einzelnen
Abgriffe angeschlossene Abgriffsdetektoren, mittels welcher
die beiden gegenläufigen Hilfssignale an den einzelnen Abgriffsstellen auf Betragsgleichheit oder Betragsungleichheit untersucht werden, wobei an den Ausgängen aller Abgriffsdetektoren das Quantisierungsmuster abnehmbar ist.

Diesem erfindungsgemäßen Analog/Digital-Wandler liegt folgendes
Funktionsprinzip zugrunde:

Speist man in die beiden entgegengesetzten Enden der einzigen
Laufzeitleitung  bzw. der beiden Laufzeitleitungen ein Hilfssignal, beispielsweise in Form eines Impulses, mit gleicher
 Phase ein, treffen sich die beiden an den entgegengesetzten
Enden eingespeisten Impulse in der Mitte der einzigen bzw.
der beiden Laufzeitleitungen. An dem Abgriff bzw. an dem
Meßpaar von Abgriffen in der Mitte der einzigen bzw. der beiden
Laufzeitleitungen kann dann das überlagerte Auftreffen der
beiden Hilfsimpulse festgestellt werden, während an allen übrigen Abgriffen bzw. Meßpaaren nur ein einfacher Impuls festgestellt wird. Der Fall, daß sich die beiden Impulse in der Mitte
der Laufzeitleitung bzw. der Laufzeitleitungen treffen, tritt
dann auf, wenn das umzusetzende Analogsignal den momentanen
Signalwert Null aufweist.

Ist dagegen der momentane Analogsignalwert von Null verschieden, wird an dem einen Ende der einzigen Laufzeitleitung bzw.
der beiden Laufzeitleitungen der Impuls mit einer zeitlichen
Verzögerung gegenüber dem auf das andere Ende gegebenen Impuls
eingespeist. Als Folge davon  treffen sich die beiden Impulse
nicht mehr in der Leitungsmitte sondern je nach Polarität des
jeweiligen Analogsignal-Momentanwertes links oder rechts von
der Leitungsmitte. Das gemeinsame Auftreffen der beiden Impulse wird dann an einem anderen Abgriff der einzigen Laufzeitleitung bzw. einem anderen Meßpaar von Abgriffen der
beiden Laufzeitleitungen festgestellt. Dabei wird die Phasenveränderungseinrichtung vorteilhafterweise so eingestellt, daß sie beim Analogsignalwert Null einen mittleren Phasenverschiebungswinkel verursacht, während sich bei einem Analogsignalwert der einen Polarität eine Verschiebung des Phasenwinkels zu einem kleineren Phasenverschiebungswinkel und bei
einem Analogsignalwert der anderen Polarität eine Verschiebung zu einem größeren Phasenverschiebungswinkel ergibt. Vorzugsweise beträgt die Phasenverschiebung bei einem Analogsignalwert Null 45° und ergibt sich bei einem von Null verschiedenen Analogsignalwert eine Änderung des Phasenverschiebungswinkels in Richtung zu 0° bzw. zu 90°.

Man kann aber als Hilfssignal auch ein Dauersinussignal verwenden. In diesem Fall kommt es aufgrund der gegenläufigen
Einspeisung der beiden Hilfssignale an den entgegengesetzten
Enden der einzigen Laufzeitleitung bzw. der beiden Laufzeitleitungen an irgendeiner Stelle längs der Laufzeitleitung bzw.
der Laufzeitleitungen zu einer Auslöschung. Dabei muß die
Leitungslänge so groß sein, daß bei der erwarteten Modulationstiefe des modulierenden Analogsignals mindestens eine Auslöschung auf der Leitungslänge sichergestellt ist. Das heißt,
die Leitungslänge muß so gewählt sein, daß auch bei dem maximal zu erwartenden Analogsignalwert und damit dem maximal zu
erwartenden Phasenunterschied zwischen den beiden gegenläufig
eingespeisten Hilfssignalwellen eine Auslöschung spätestens am
ersten oder letzten Abgriff bzw. Meßpaar der Laufzeitleitungsanordnung auftritt.

Das Zusammentreffen der beiden gegenläufigen Hilfssignalimpulse
bzw. das Auslöschen der beiden gegenläufigen Hilfssignalwellen
wird mittels Abgriffsdetektoren festgestellt. Im Fall eines
Hilfssignals in Form einer Dauersinuswelle verwendet man vorzugsweise Abgriffsdetektoren in Form von Schwellenwertschaltungen, beispielsweise Dioden oder Komparatoren, die den am jeweiligen Abgriff auftretenden Spannungswert mit einem Bezugswert vergleichen, oder andere Schwellenwertschaltungen. Dem Spannungswert Null oder einem minimalen Spannungswert am Ort
der Auslöschung kann man dann beispielsweise den Logikwert
"0" zuordnen, während man Spannungswerte, die über Null bzw.
über diesem Minimalwert liegen, als Logikwert "1" definiert.
Entlang den Abgriffen ergibt sich somit ein Logikwertmuster,
das an irgendeinem Abgriff bzw. Meßpaar den Logikwert "0" zeigt,
an allen anderen Abgriffen bzw. Meßpaaren dagegen den Logikwert "1". Je nachdem wie hoch man die Schwellenwerte zwischen
den Logikwerten "0" und "1" legt, zeigt nur der eine Abgriff
bzw. das eine Meßpaar am Ort der Auslöschung den Logikwert "0"
oder zeigen  in symmetrischer Verteilung um diesen Abgriff bzw.
dieses Meßpaar auch noch die benachbarten Abgriffe bzw. Meßpaare den Logikwert "0". Bei einer Änderung des Analogsignalwertes ändert sich das Logikwert-Verteilungsmuster, das direkt
als digitaler Code für den Analogsignal-Momentanwert benutzt
werden kann.

Im Fall der Verwendung von Hilfssignal-Impulsen stellt man
bei Verwendung nur einer einzigen Laufzeitleitung den Ort der
Überlagerung der beiden gegenläufigen Impulse als maximalen
Spannungswert fest,  der   durch geeignete Wahl des Schwellenwertes der  Abgriffsdetektoren herausgefunden werden kann. Im
Fall der Verwendung zweier Laufzeitleitungen verwendet man vorzugsweise pro Meßpaar ein UND-Glied, dessen Ausgangszustand anzeigt, ob an dem zugehörigen Meßpaar eine Überlagerung der
beiden gegenläufigen Hilfssignalimpulse auftritt oder nicht.
Das UND-Glied an dessen Abgriffen die Überlagerung der beiden
gegenläufigen Hilfssignalimpulse festgestellt wird, gibt beispielsweise den Logikwert "1" an,  während die Ausgänge der
anderen UND-Glieder den Logikwert "0" zeigen. Auch aus diesem
Logikwert-Verteilungsmuster kann wieder auf den Analogsignal-
Momentanwert geschlossen werden, und auch dieses Logiksignal-
Verteilungsmuster kann wieder  als digitaler Code für den
Analogsignal-Momentanwert verwendet werden.

0154663

Es können in diesem Fall auch andere Verknüpfungsglieder als
Abgriffsdetektoren verwendet werden, beispielsweise NAND-Glieder.
In diesem Fall tritt ein komplementäres Logikwert-Verteilungsmuster auf.

Man kann für die Phasenveränderungseinrichtung einen einzigen
Phasenschieber verwenden, der zwischen die Hilfssignalquelle
und den einen Eingang der Laufzeitleitungsanordnung geschaltet
wird. Vorzugsweise werden zwei Phasenschieber benutzt, die je
zwischen die Hilfssignalquelle und einen Leitungseingang geschaltet werden.

Vorzugsweise werden die Ausgänge der Abgriffsdetektoren auf
die parallelen Eingänge einer Speichereinrichtung gegeben, in
welche die jeweiligen Quantisierungsmuster eingelesen werden
können. Aus diesem Speicher können die Quantisierungsmuster
dann  taktweise ausgelesen werden, wobei der  Auslesetakt
vom Einlesetakt verschieden sein kann.

Die Laufzeitleitungen können beispielsweise als Koaxialkabel,
Streifenleitungen, Hohlleiter oder auch Kettenleiter beispielsweise mit LC-Gliedern aufgebaut sein.  .

Eine weitere Möglichkeit für eine erfindungsgemäße verwendbare Laufzeitleitung ist die Hintereinanderschaltung einer Mehrzahl von Gattern, die je ein Verzögerungsglied bilden.

Der erfindungsgemäße Analaog/Digitalwandler läßt sich in
vorteilhafter Weise als Stufenschalter einsetzen, der mehrere
Schalterausgänge aufweist, an denen der Reihe nach in zeitlicher Versetzung Schaltsteuersignale auftreten. Zu diesem
Zweck legt man an die steuerbare Phasenveränderungseinrichtung als Analogsignal ein Sägezahnsignal an. Der Ort  längs
der Laufzeitleitungsanordnung, an dem Koinzidenz der beiden
Hilfssignale auftritt, ändert sich mit dem Sägezahnverlauf.

Der Logikwert, der an demjenigen Abgriffsdetektor erscheint, bei welchem jeweils die Koinzidenz auftritt, wandert dann der Reihe nach mit zeitlicher Versetzung von Abgriffsdetektor zu Abgriffsdetektor. Dieser Logik-wert kann, gegebenenfalls nach einer Inversion, "0" oder "1" sein. Die einzelnen Abgriffsdetektoren bilden dabei die einzelnen Ausgänge des Stufenschalters. Betrachtet man beispielsweise einen Stufenschalter mit vier Ausgängen, denen je ein Abgriffsdetektor zugeordnet ist, so tritt das Schaltsteuersignal, beispielsweise der Logikwert "1", jeweils immer nur an einem Schalterausgang auf, nämlich am ersten Schalterausgang zum Zeitpunkt t1, am zweiten Schalterausgang zum Zeitpunkt t2, am dritten Schalterausgang zum Zeitpunkt t3 und am vierten Schalterausgang zum Zeitpunkt t4. Nimmt man zum Beispiel gleiche Abstände der den Abgriffsdetektoren zugeordneten Abgriffe voneinander an, tritt der den Ort der Koinzidenz kennzeichnende Logikwert an benachbarten Abgriffsdetektoren mit gleichen Zeitabständen $\Delta$ t auf.

Durch Verändern des Anstieges des Sägezahnsignals kann man nun die Zeitlagen der Zeitpunkte t1 bis t4 und die zeitlichen Ab-stände $\Delta$ t zwischen ihnen variieren.

Ein solcher Stufenschalter läßt sich zum Beispiel zur variablen Steuerung von Multiplexsystemen verwenden. Lediglich durch Verändern der Steigung des analogen Sägezahnsignals lassen sich die Zeitlagen und Zeitlagenabstände des Multiplexsystems variieren.

Die Erfindung und Weiterbildungen der Erfindung werden im folgenden anhand von Ausführungsformen näher erläutert. In der Zeichnung zeigen:

Fig. 1    eine erste Ausführungsform eines erfindungsgemäßen
          Analog/Digital-Wandlers mit zwei Laufzeitleitungen;
          und

Fig. 2    eine zweite Ausführungsform des erfindungsgemäßen Analog/
          Digital-Wandlers mit einer einzigen Laufzeitleitung.

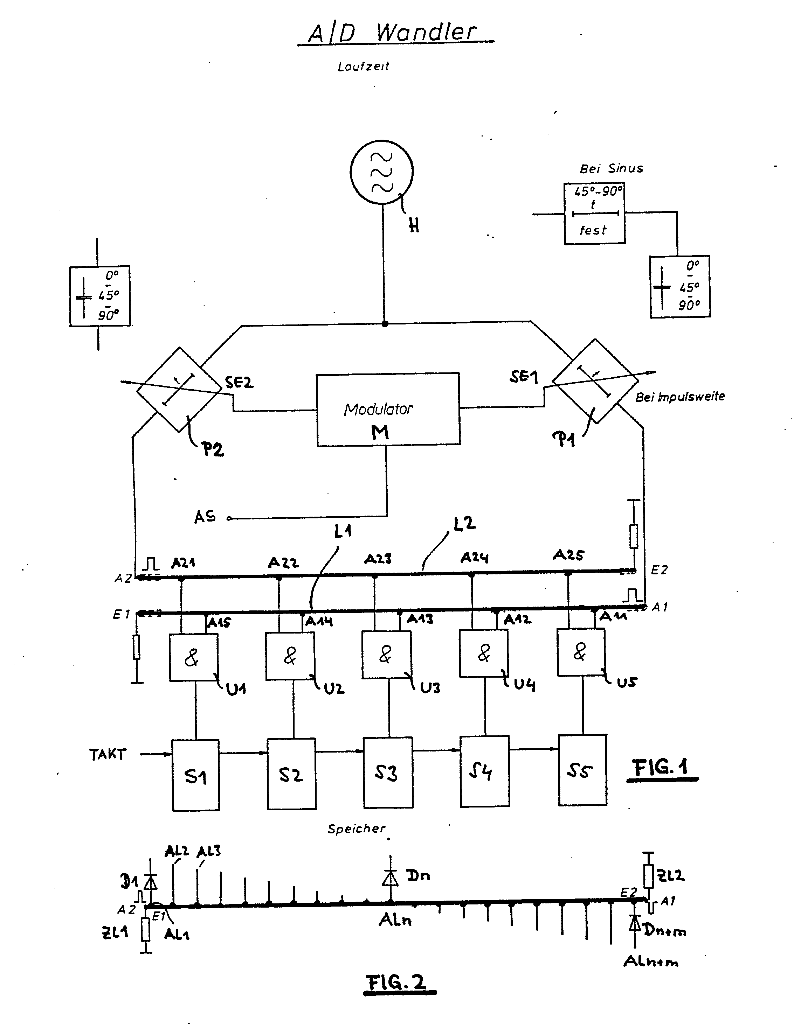

Gemäß Fig. 1 sind zwei nebeneinander liegende und im wesentlichen gleich lange Laufzeitleitungen L1 und L2 vorgesehen,
die an entgegengesetzten Leitungsenden A1 bzw. A2 über je
einen Phasenschieber P1 bzw. P2 mit einer Hilfssignalquelle H verbunden sind. Die jeweils anderen Enden E1 bzw. E2 der beiden Laufzeitleitungen L1 und L2 sind je mit einer Impedanz Z1 bzw. Z2 abgeschlossen, deren Impedanzwert gleich dem Wellenwiderstand der zugehörigen Laufzeitleitung ist. Hilfssignale in Form von periodischen Impulsfolgen, die von der Hilfssignalquelle H abgegeben werden, können von den Phasenschiebern P1 und P2 unterschiedlich phasenverschoben bzw. verzögert werden. Die Phasenschieber P1 und P2 sind hinsichtlich ihres Phasenverschiebungswinkels steuerbar. Ihren Steuereingängen SE1 bzw. SE2 wird von einem Modulator M ein vom umzusetzenden Analogsignal AS abhängendes Steuersignal zugeführt. Die beiden Phasenschieber sind vorzugsweise so ausgelegt, daß sie bei einem Analogsignalwert Null einen gleichen, mittleren Phasenverschiebungswinkel von vorzugsweise 45° bewirken. Bei einem von Null verschiedenen Analogsignalwert ändert sich diese Phasenverschiebung je nach Polarität dieses Analogsignalwertes in Richtung auf 0° oder in Richtung auf 90°. Dabei wirken die beiden Phasenschieber P1 und P2 gegenläufig, das heißt, wenn ein Analogsignalwert einer bestimmten Polarität im einen Phasenschieber eine Phasenwinkeländerung in Richtung auf 90° verursacht, bewirkt sie im anderen Phasenschieber eine Phasenänderung in Richtung auf 0°.

Bei einem Analogsignalwert Null werden die Hilfssignalimpulse somit in die beiden Leitungsanfänge A1 und A2 der beiden Laufzeitleitungen L1 und L2 mit gleicher Phasenverzögerung, also gleichzeitig eingespeist, so daß sie sich in der Mitte beider Laufzeitleitungen treffen. Werden die in die beiden Laufzeitleitungen L1 und L2 eingespeisten Hilfssignalimpulse von den Phasenschiebern P1 und P2 unterschiedlich verzögert, treffen sich die beiden Hilfssignalimpulse an Stellen der beiden Laufzeitleitungen, die links oder rechts von der Mitte liegen.

Wo sich die beiden Hilfssignalimpulse treffen, wird mit Hilfe von Abgriffen A11, A12, A13, ... der ersten Laufzeitleitung L1 und Abgriffen A21, A22, A23, ... der zweiten Laufzeitleitung L2 ermittelt. Dabei weisen die Abgriffe A11, A12, ... der ersten Laufzeitleitung L1 von deren Leitungsanfang A1 jeweils gleichen Abstand auf wie die Abgriffe A21, A22, ... vom Leitungsanfang A2 der zweiten Laufzeitleitung L2. Je zwei einander benachbarte Abgriffe der beiden Laufzeitleitungen bilden ein Meßpaar A11, A25; A12, A24; ... . Jedem Meßpaar ist ein UND-Glied U1, U2 ... mit je zwei Eingängen zugeordnet. An die beiden Eingänge jedes UND-Gliedes U1, U2, ... sind die Abgriffe A11, A25 bzw. A12, A24 ... je eines Meßpaares angeschlossen.

In der dargestellten Ausführungsform sind nur fünf Meßpaare mit fünf zugehörigen UND-Gliedern dargestellt. Zum Erhalt einer Analog/Digital-Umsetzung mit niederigem Quantisierungsfehler wird man bei praktischen Ausführungsformen eine viel größere Anzahl von Abgriffspaaren und UND-Gliedern vorsehen. Je größer und dichter die Meßpaare sind, um so genauer ist die Analaog/Digital-Umsetzung und um so geringer sind Quantisierungsrauschen und Quantisierungsfehler.

Liegt beispielsweise wieder ein Analogsignalwert Null vor, so daß die Signal-Impulse gleichphasig gegenläufig in die beiden Laufzeitleitungen L1 und L2 eingespeist werden, treffen sie sich am mittleren Meßpaar A13, A23, so daß am mittleren UND-Glied U3 das gemeinsame Auftreten der beiden Impulse gemeldet wird, und zwar als Logikwert "1" am Ausgang des UND-Gliedes U3. Ist der Analogsignalwert jedoch von Null verschieden, werden die Hilfssignal-Impulse mit einer Phasenverzögerung zueinander auf die beiden Laufzeitleitungen gegeben, so daß sie sich an einem anderen Meßpaar treffen und an dem Ausgang des diesem anderen Meßpaar zugeordneten UND-Gliedes der Logikwert "1" auftritt. Bei den jeweils anderen Meßpaaren
kann das Zusammentreffen der Hilfssignalimpulse auf den beiden
Laufzeitleitungen L1 und L2 nicht festgestellt werden, so daß
die Ausgänge der ihnen zugeordneten UND-Glieder den Logikwert
"0" zeigen. Somit ergibt sich an den Ausgängen der UND-Glieder
ein Logikwertmuster in Form einer Verteilung der Logikwerte
"0" und "1", das als Codierung des umgesetzten Analogsignalwertes betrachtet werden kann. Dieses Logiksignalmuster verändert sich in Abhängigkeit von dem  umzusetzenden Analogsignalwert und stellt das jeweilige Digitalmuster des Analogsignalwertes dar.

Bei der in Fig. 1 gezeigten Ausführungsform werden  Logikwerte an den Ausgängen der UND-Glieder U1, U2, ... parallel
in die einzelnen Speicherstufen S1, S2, ... eines Speichers
eingelesen, aus dem sie dann bei Bedarf und mit  dem gewünschten Takt zur  weiteren Verarbeitung ausgelesen werden
können.

Je größer die Phasenänderungsmodulationstiefe gemacht wird,
um so länger müssen die beiden Laufzeitleitungen L1 und L2
sein, damit bei großem Phasenunterschied zwischen den gegenläufig in die beiden Laufzeitleitungen L1 und L2 eingespeisten
Hilfssignal-Impulse noch ein Zusammentreffen der Hilfssignalimpulse an einer Stelle der beiden Laufzeitleitungen L1 und
L2 möglich ist. Ordnet man den Ausgängen der UND-Glieder U1,
U2, ... Abtast- und Halteschaltungen zu , mit denen das Logikwertmuster an den Ausgängen der UND-Glieder U1, U2, ... bis
zu dem Zeitpunkt, zu welchem die beiden Hilfssignal-Impulse die
jeweilige  Laufzeitleitung L1 bzw. L2 durchlaufen haben und
nach welchem dann die Übernahme des Logikwertmusters in die
Speicherstufen S1, S2, ... vorgenommen werden kann, muß man
bei großer Modulationstiefe einen relativ großen Abstand
zwischen den aufeinanderfolgenden Hilfssignal-Impulsen einhalten. Um mit höherer Abtastfrequenz arbeiten zu können,
empfiehlt es sich daher, eine hohe Quantisierungsauflösung nicht durch Vergrößerung der Modulationstiefe sondern durch eine Vergrößerung der Anzahl der Meßpaare und eine entsprechend dichtere Aufeinanderfolge der Meßpaare zu erwirken.

Bei der in Fig. 2 dargestellten Ausführungsform des erfindungsgemäßen Analog/Digital-Wandlers wird nur eine einzige Laufzeitleitung L verwendet, die beidseits gegenläufig mit den Hilfssignalen gespeist wird. Jedes Ende dieser Laufzeitleitung L dient somit gleichermaßen als Leitungsanfang A1 bzw. A2 und als Leitungsende E1 bzw. E2. Jedes Leitungsende dient einerseits als Einspeisstelle A1 bzw. A2 für das Hilfssignal und ist andererseits als Leitungsende E1 und E2 mit einer Impedanz mit einem Impedanzwert gleich dem Wellenwiderstand der Laufzeitleitung abgeschlossen. Mindestens einer der beiden Einspeispunkte A1 und A2 ist über einen Phasenschieber mit der Hilfssignalquelle verbunden. Vorzugsweise sind - wie im Fall der Ausführungsform nach Fig. 1 - beide Einspeispunkte A1 und A2 über einen Phasenschieber P1 bzw. P2 mit der Hilfssignalquelle H verbunden. Bei der Ausführungsform in Fig. 2 muß man sich also die Ausgänge der beiden Phasenschieber P1 und P2 in Fig. 1 an die Einspeispunkte A1 bzw. A2 angeschlossen vorstellen, obwohl dies nicht dargestellt ist.

Längs der Laufzeitleitung L sind wieder Abgriffe AL1, AL2,... ALn, ... ALn+m angeordnet, an die jeweils eine Diode D1, D2, ... Dn... Dn+m angeschlossen sind. In Fig. 2 sind nur drei dieser Dioden dargestellt. In der Praxis ist jedoch jeder Abgriff mit einer Diode verbunden.

Bei der in Fig. 2 dargestellten Ausführungsform werden die Hilfssignal-Impulse mit entgegengesetzter Polarität in die beiden Leitungsanfänge A1 und A2 eingespeist. Geht man beispielsweise wieder davon aus, daß momentan ein Analogsignalwert Null umzusetzen ist, d.h., daß die Hilfssignal-Impulse beiden Endes der Laufzeitleitung L gleichzeitig eingespeist
werden, wenn auch mit unterschiedlicher Polarität, dann kommt
es in der Leitungsmitte am Abgriff ALn  zu einer Auslöschung
der Impulse. Bei der Umsetzung eines von Null verschiedenen
Analogsignalwertes verschiebt sich der Auslöschungspunkt längs
der Laufzeitleitung L in Abhängigkeit vom Betrag und vom Vorzeichen des Analogsignalwertes mehr oder weniger nach links
oder  rechts von der Leitungsmitte.  Die Leitungslänge  muß
wieder so bemessen sein, daß sich bei der maximalen Modulationstiefe eine Auslöschung spätestens am ersten Abgriff
AL1 bzw. am letzten Abgriff ALn+m ergibt. Auch hier kann man
die Auflösung wieder durch Verdichtung der  Aufeinanderfolge
der einzelnen Abgriffe erhöhen.

Der Zustand Auslöschung oder Nichtauslöschung an den einzelnen
Abgriffen kann wieder als Quantisierungsmuster des umgesetzten Analogsignalwertes behandelt werden. In der in Fig. 2
dargestellten Ausführungsform sind an die  einzelnen Abgriffe
die Dioden D1, D2, ... Dn... Dn+m angeschlossen, die gewissermaßen als Schwellenwertelemente dienen. Im Hinblick auf
die Einspeisung der Hilfssignal-Impulse in die beiden Leitungsenden A1 und A2 mit entgegengesetzter Polarität sind die
Dioden in Fig. 2 rechts von der Leitungsmitte mit ihren
Kathoden an die Angriffe angeschlossen, in der in der Zeichnung
linken Hälfte dagegen mit den Anoden. Vorzugsweise werden jedoch alle Dioden mit gleicher Polarität an die Laufzeitleitung
angeschlossen.

An die einzelnen Abgriffe können auch andersartige Abgriffsdetektoren angeschlossen werden, z.B. Komparatoren, die mit
dem jeweils nicht mit einem Abgriff verbundenen Eingang an
ein Bezugspotential gelegt sind, oder Schwellenwertdetektoren.
Je nachdem, wie hoch man die Schwellenwerte legt, zeigt nur
der Ausgang eines Schwellenwertdetektors bzw. eines Komparators
einen Logikwert "0",während alle anderen Schwellenwertdetektoren oder Komparatoren am Ausgang den Logikwert "1" zeigen, oder es treten noch beiseits des Abgriffs, an dem Auslöschung
der beiden gegenläufigen Impulse festgestellt wird, Logikwerte "0" auf. Das an den Ausgängen der Schwellenwertdetektoren oder Komparatoren auftretende Logikwertmuster stellt dann
wieder eine digitale Codierung des umgesetzten Analogsignalwertes dar.

Als Laufzeitleitungen können beispielsweise Koaxialkabel,
Streifenleitungen und Hohlleiter verwendet werden. Es besteht
auch die Möglichkeit, die Laufzeitleitungen als Kettenleitungen aus einzelnen LC-Gliedern aufzubauen.

KADOR · KLUNKER · SCHMITT-NILSON · HIRSCH

PATENTANWÄL
EUROPEAN PATENT ATTORN

DR. UTZ KADOR, DIPL.-CH.
DR. FRIEDER KLUNKER, DIPL.-I
DR. GERT SCHMITT-NILSON, DIPL.-I
PETER HIRSCH, DIPL.-I

D-8000 MÜNCHE
CORNELIUSST

TELEPHONE (089)-201
TELECOPIER (089)-201
TELEX 5-23517 1
CABLE b

KADOR KLUNKER SCHMITT-NILSON HIRSCH CORNELIUSSTRASSE 15 8000 MÜNCHEN 5

Hans WERBA
Theresienstraße 11
8390 Passau

u.Z.: K 21 194 K6-eb

---

Analog/Digital-Wandler

---

Patentansprüche

1.    Analog/Digital-Wandler
g e k e n n z e i c h n e t
durch eine Laufzeitleitungsanordnung (L; L1, L2), die entlang
ihrer Länge mit einer Anzahl Abgriffen (AL1, AL2, ...; A11,
A12, ..., H21, H22, ...) versehen ist und beiden Endes mit
Hilfssignalen gleicher Signalform von einer Hilfssignalquelle
(H) gespeist wird,
durch eine steuerbare Phasenveränderungseinrichtung (P1, P2),
mittels der unter Steuerung durch das umzusetzende Analogsignal (AS) ein Phasenunterschied zwischen den beiden gegenläufigen Hilfssignalen auf der Laufzeitleitungsanordnung (L;
L1, L2) entsprechend der Analogsignaländerung modulierbar ist,
und durch an die einzelnen Abgriffe (AL1, AL2, ...; A11, A12,...
A21, A22, ...) angeschlossene Abgriffsdetektoren (D1, D2, ...;
U1, U2, ...), mittels welcher die beiden gegenläufigen Hilfssignale an den einzelnen Abgriffsstellen auf Betragsgleichheit oder Betragsungleichheit untersucht werden,
wobei an den Ausgängen aller Abgriffsdetektoren (D1, D2;...
U1, U2) das Quantisierungsmuster abnehmbar ist.

2.     Analog/Digital-Wandler nach Anspruch 1, dadurch gekennzeichnet, daß die Laufzeitleitungsanordnung durch eine Laufzeitleitung (L) gebildet ist, in welche die Hilfssignale von
den entgegengesetzten  Enden (A1, A2) gegenläufig einspeisbar
sind.

3.     Analog/Digital-Wandler nach Anspruch 2, dadurch gekennzeichnet, daß an jeden Abgriff (AL1, AL2, ...) als Abgriffsdetektor eine Diode (D1, D2, ...) angeschlossen ist.

4.     Analog/Digital-Wandler nach Anspruch 1, dadurch gekennzeichnet, daß die Laufzeitleitungsanordnung zwei Laufzeitleitungen (L1, L2) aufweist, die je an zueinander entgegengesetzten
Enden (A1, A2)     mit dem Hilfssignal speisbar sind und Abgriffe (A11, A12, ... A21, A22, ...) in gleichen Abständen
vom Leitungsanfang (A1) der einen Laufzeitleitung (L1) bzw.
vom Leitungsende (A2) der anderen Laufzeitleitung (L2) aufweisen, von denen je zwei einander gegenüberliegende Abgriffe
(A11, A25 oder A12, A24, ...) der beiden Laufzeitleitungen
(L1, L2) ein Meßpaar bilden,
und daß an die beiden Abgriffe jedes Meßpaares je ein Abgriffsdetektor in Form einer Vergleichsvorrichtung (U1, U2,...)
angeschlossen ist.

5.     Analog/Digital-Wandler nach Anspruch 4, dadurch gekennzeichnet, daß die Vergleichsvorrichtungen durch UND-Glieder
(U1, U2, ...) gebildet sind, die je mit einem ersten Eingang
mit dem einen und mit einem zweiten Eingang mit dem anderen Abgriff eines Meßpaares verbunden sind und an deren Ausgängen das Quantisierungsmuster abnehmbar ist.

6.    Analog/Digital-Wandler nach einem oder mehreren der Ansprüche 1 bis 5, dadurch gekennzeichnet, daß die Phasenveränderungseinrichtung durch einen steuerbaren Phasenschieber (P1) gebildet ist, der zwischen die Hilfssignalquelle (H) und den gespeisten Eingang (A1) der einen (L1) bzw. der einzigen Laufzeitleitung (L) geschaltet ist und dessen Steuereingang (SE1) mit dem umzusetzenden Analogsignal (AS) beaufschlagbar ist.

7.    Analog/Digital-Wandler nach einem oder mehreren der Ansprüche 1 bis 5, dadurch gekennzeichnet, daß die Phasenveränderungseinrichtung durch zwei steuerbare Phasenschieber (P1, P2) gebildet ist, die je zwischen die Hilfssignalquelle (H) und einen der beiden gespeisten Eingänge (A1 bzw. A2) der beiden (L1, L2) bzw. der einzigen (L) Laufzeitleitung geschaltet sind und deren Steuereingänge (SE1, SE2) mit dem umzusetzenden Analogsignal (AS) beaufschlagbar sind, und daß die beiden Phasenschieber (P1, P2) auf das Analogsingal (AS) mit gegensinniger Phasenänderung reagieren.

8.    Analog/Digital-Wandler nach Anspruch 6 oder 7, dadurch gekennzeichnet, daß der bzw. die Phasenschieber (P1, P2) bei einem Analog-Signalwert Null auf einen Phasenverschiebungswinkel von 45 ° eingestellt ist bzw. sind, von dem aus er bzw. sie je nach Polarität des Analogsignals (AS) in Richtung auf 0° bzw. auf 90° verschiebbar sind.

9.    Analog/Digital-Wandler nach einem oder mehreren der Ansprüche 1 bis 8, dadurch gekennzeichnet, daß die Hilfssignalquelle (H) als Hilfssignal Einzelimpulse, vorzugsweise in Form einer periodischen Impulsfolge, liefert.

- 4 -

0154663

10. Analog/Digital-Wandler nach einem oder mehreren der Ansprüche 1 bis 8, dadurch gekennzeichnet, daß die Hilfssignalquelle (H) ein Dauersinussignal liefert.

11. Analog/Digital-Wandler nach einem oder mehreren der Ansprüche 1 bis 10, dadurch gekennzeichnet, daß an die nicht mit den Abgriffen (AL1, AL2, ...; A11, A12, ... A21, A22, ...) verbundenen Seiten der Abgriffsdetektoren (D1, D2, ...; U1, U2, ...) die parallelen Eingänge einer Speichereinrichtung (S1, S2, ...) angeschlossen sind, in welche die Quantisierungsmuster taktweise einspeicherbar sind.

12. Verwendung des Analog/Digital-Wandlers nach einem oder mehreren der vorausgehenden Ansprüche als Stufenschalter, dadurch gekennzeichnet,
daß der Phasenveränderungseinrichtung (M, P1, P2) als Analogsignal ein Sägezahnsignal zugeführt wird
und daß die Ausgänge der Abgriffsdetektoren die einzelnen Schalterausgänge bilden, an denen der Reihe nach mit zeitlicher Versetzung Schaltsteuersignale auftreten, wobei der zeitliche Abstand ($\Delta$t) zwischen den Schaltsteuersignalen an den einzelnen Schalterausgängen durch die Anstiegssteigung des Sägezahnsignals steuerbar ist.

0154663

A/D Wandler

Laufzeit

FIG. 1

FIG. 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | ELEKTRONIK, Band 31, Nr. 19, 24. September 1982, Seite 28, München, DE; "A/D-Umsetzer für 1 GHz"<br><br>--- | | H 03 M 1/64 |
| A | GB-A-1 113 431 (EMI)(15.05.1968)<br><br>----- | | |
| | | | **RECHERCHIERTE SACHGEBIETE (Int. Cl.4)**<br><br>H 03 M |

Der vorliegende Recherchenbericht wurde für alle Patentansprüche erstellt.

| Recherchenort | Abschlußdatum der Recherche | Prüfer |
|---|---|---|
| DEN HAAG | 15-11-1984 | BEINDORFF W.H. |